Europäisches Patentamt

European Patent Office

Office européen des brevets

(19)

(11) Numéro de publication: **0 084 986**
**B1**

(12) **FASCICULE DE BREVET EUROPEEN**

(45) Date de publication du fascicule du brevet:
02.10.85

(51) Int. Cl.⁴: **C 04 B 35/10,** H 01 L 23/14,
H 01 L 21/48

(21) Numéro de dépôt: 83400022.6

(22) Date de dépôt: **04.01.83**

(54) Composition céramique à base d'alumine pour la réalisation de substrats ainsi qu'un procédé de réalisation de tels substrats.

(30) Priorité: 12.01.82 FR 8200373

(43) Date de publication de la demande:
03.08.83 Bulletin 83/31

(45) Mention de la délivrance du brevet:
02.10.85 Bulletin 85/40

(84) Etats contractants désignés:
DE GB IT NL SE

(56) Documents cités:
FR - A - 1 388 155
FR - A - 2 394 506
GB - A - 1 386 119
US - A - 3 516 840
US - A - 4 045 412

(73) Titulaire: C.I.C.E. S.A., 67 rue Desnouettes,
F-75015 Paris (FR)

(72) Inventeur: Gougouyan, Yves, THOMSON-CSF
SCPI 173, bld Haussmann, F-75379 Paris Cedex 08 (FR)
Inventeur: Basseville, Philippe, THOMSON-CSF
SCPI 173, bld Haussmann, F-75379 Paris Cedex 08 (FR)

(74) Mandataire: Rinuy, Santarelli, 14, avenue de la Grande
Armée, F-75017 Paris (FR)

BUNDESDRUCKEREI BERLIN

## Description

La présente invention concerne une composition céramique à base d'alumine pour la réalisation de substrats ainsi qu'un procédé de réalisation de rels substrats.

Les substrats céramiques sont actuellement très utilisés dans l'industrie électronique notamment pour la réalisation de supports de circuits intégrés (»chip-carrier« selon la dénomination anglo-saxonne) ou comme support de circuits hybrides. On réalise sur ces substrats des réseaux de connexions électriques qui permettent de relier les composants, tels que les circuits intégrés, aux éléments électriques de l'appareil dans lequel est monté ce substrat céramique. Ces réseaux de connexions électiques sont généralement réalisés soit selon la technique dite en »couche épaisse« (par une méthode de sérigraphie, par exemple) soit selon la technique dite en »couche mince« (par une méthode du type dépôt sous vide, par exemple). La première de ces techniques peut être utilisée dans tous les cas mais plus particulièrement lorsque la rugosité moyenne du substrat est assez élevée (supérieure à 0,254 µm (10 micro-inchs), tandis que la seconde ne peut être utilisée que pour les substrats de faible rugosité. La première technique est plus facile et plus économique à mettre en oeuvre, mais ne permet pas l'obtention de motifs fins.

Parmi les solutions industrielles de mise en oeuvre des compositions céramiques pour la réalisation des substrats, à savoir principalement le coulage, le pressage mécanique et le pressage isostatique, le second est le plus recherché pour sa simplicité en particulier lorsqu'il s'agit de réaliser directement des pièces prêtes à être frittées dans un four. En effet, la pièce étant moulée directement, l'étape de découpe existant soit dans le procédé de coulage, soit dans le procédé de pressage isostatique est ainsi évitée, de même que éventuelles opérations de perçage de la pièce en concevant le moule façon adéquat. Il suffit de prévoir dans le moule des broches correspondant aux trous du substrat. Ce procédé particulièrement économique, ne permet pas toutefois de fabriquer directement des substrats céramiques du type »couches minces« avec les compositions céramiques bien connues de l'homme de métier. En effet, les pièces obtenues ont une rugosité beaucoup trop élevée et il est nécessaire de pratiquer alors une opération de rectification sur la surface du substrat pour rendre celui-ci apte au dépôt de couches minces.

Il es connu du brevet français 1 388 155 d'utiliser des agents défloculants dans les compositions céramique à base d'alumine afin de les rendre aptes au pressage mécanique ou isostatique. Il est également connu de ce brevet français d'ajouter une certaine quantité de liants pour permettre à l'objet pressé d'avoir une certaine »tenue« et ne pas se déformer au cours de l'opération de frittage. Toutefois, les compositions décrites dans ce brevet ne permettent pas de réaliser des pièces de forme compliquée ayant une faible rugosité après frittage, inférieure à 0,254 µm (10 micro-inchs), sans opération de rodage mécanique. En particulier, on a constaté que l'utilisation des différentes compositions décrites dans ce brevet ne permettait pas d'obtenir des substrats céramiques de faible rugosité, substrats percés de trous obtenus directement par pressage mécanique. Ainsi, le brevet français 2 394 506 et le brevet américain 40 45 412 dérivent des procédés de fabrication de substrats par coulée sur un support lisse du type film de polyterephtalate d'éthylène. Un tel procédé néssite de réaliser ensuite les trous de passage des connescions, par une opération mécanique supplémentaire, délicate et onéreuse.

La composition céramique selon l'invention permet de résoudre le problème posé et d'obtenir directement des pièces pressées mécaniquement ayant une faible rugosité. La composition céramique, selon l'invention, est caractérisée en ce qu'elle est constituée, en extrait sec, de 95 à 99% en poids d'un mélange d'une première alumine ayant une granulométrie comprise entre 0,4 et 0,8 µm, une densité en cru comprise entre 2,00 et 2,20, une densité en cuit comprise entre 3,85 et 3,96 pour une température de frittage de 1450°C à 1580°C, et d'une seconde alumine ayant une granulométrie comprise entre 1,2 et 1,6 µm, une densité en cru inferieure à 2,4, une densité en cuit comprise entre 3,85 et 3,96 pour une température de frittage de 1580°C à 1650°C et de 1 à 5% en poids de produits organiques comportant au moins un défloculant et au moins un liant acrylique, à base d'homo ou de copolymères de polyacrylate d'alkyle.

De préférence, on obtient de meilleurs résultats (faible rugosité, facilité de mise en oeuvre de la composition), en utilisant de 97 à 98,5% en poids du mélange d'alumine et de 1,5 à 3% en poids de produits organiques. Le mélange d'alumine comportera généralement de 65 à 95% en poids de la première alumine et de 35 à 5% en poids de la seconde, les meilleurs résultats du point du vue de la rugosité du substrat étant obtenus pour un mélange d'alumine comportant de 70 à 80% en poids de la première alumine et de 30 à 20% en poids de la seconde.

Pour pouvoir réaliser un pressage mécanique de la composition selon l'invention, il est nécessaire que celle-ci comporte des liants organiques du type acrylique tels que ceux qui sont utilisés dans les peintures, ces liants devant être compatibles avec l'eau car les barbotines utilisant les compositions céramiques sont toujours à base d'eau. On a, en effet, constaté que l'utilisation de liants acryliques tels que les homo ou copolymères à base de polyacrylates d'alkyle en général et plus particulièrement le polyacrylate de butyle sous forme d'homopolymère ou copolymérisé avec l'acrylonitrile permettaient d'obtenir des compositions pressables mécaniquement sans difficultés, tout en utilisant le mélange d'alumines cité plus haut les substrats obtenus après frittage étant de faible rugosité. Les meilleurs résultats de pressage mécanique sont obtenus avec une quantité de liants acryliques comprise entre 1 et 3% en poids par rapport au poids total de la composition.

Les compositions céramiques selon l'invention pourront comporter également de 0 à 5% en poids d'ajouts minéraux habituellement utilisés en céramique tels que les oxydes de calcium, magnésium, les oxydes métalliques, la silice, etc. . ., oxydes ayant des propriétés bien connues de l'homme de métier. Les meilleurs résultats du point de vue rugosité sont obtenus en additionnant aux compositions ci-dessus de 0 à 1% en poids de ces ajouts minéraux. La granulométrie sera de préférence inférieure à 2 μm tandis que leus température de frittage sera inférieure à 1620° C pour une densite en eru inférieure à 2,45. Pour plus de précision concernant les compositions céramiques habituellement utilisées et leur mise en oeuvre ainsi que les adjuvants utilisés, on pourra se reporter au brevet français 1 388 155.

Le procédé pour réaliser un substrat céramique du type »couche mince« comportant une pluralité de trous et ayant une rugosité inférieure à 0,254 μm (10 microinches), est caractérise en ce qu'il consiste à:

— réaliser une barbotine comportant de 50 à 75% en poids d'extraits secs constitués d'une composition céramique conforme à l'une des revendications précédentes;
— atomiser cette barbotine, puis la tamiser de manière à obtenir un granulé dont la taille des particules est comprise entre 80 et 250 μm;
— presser mécaniquement cette composition dans un moule de manière à obtenir un substrat, ledit substrat ayant des broches correspondant aux trous du substrat;
— fritter ce substrat à une température de l'ordre de 1600° C;
— realiser un auto-polissage dans un tonneau rempli d'eau d'une pluralité de substrats frittés.

L'invention sera mieux comprise à l'aide des exemples de réalisation suivants, donnés à titre non limitatif, conjointement avec les figures qui représentent:
— la figure 1, une vue schématique d'un substrat céramique obtenu par pressage mécanique avec une composition de l'invention,
— la figure 2, des vues de détail du moule permettant d'obtenir le substrat de la figure 1.

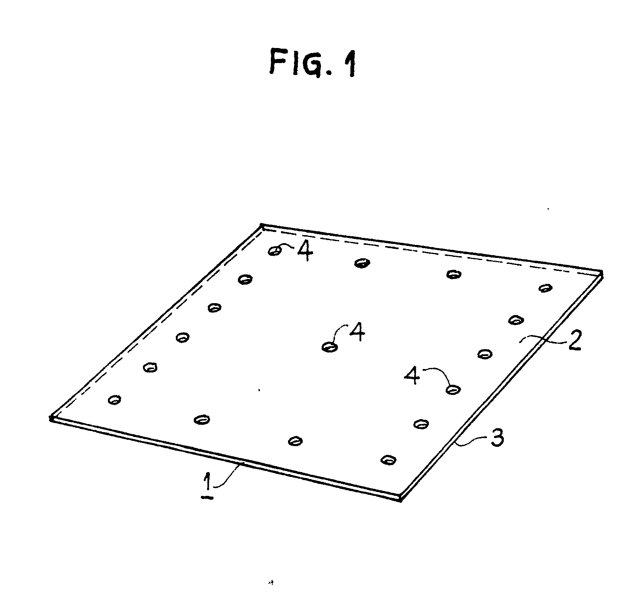

Sur la figure 1, on a représenté un substrat céramique de type connu mais qui ne pouvait être obtenu jusqu'à présent par pressage mécanique avec une faible rugosité.

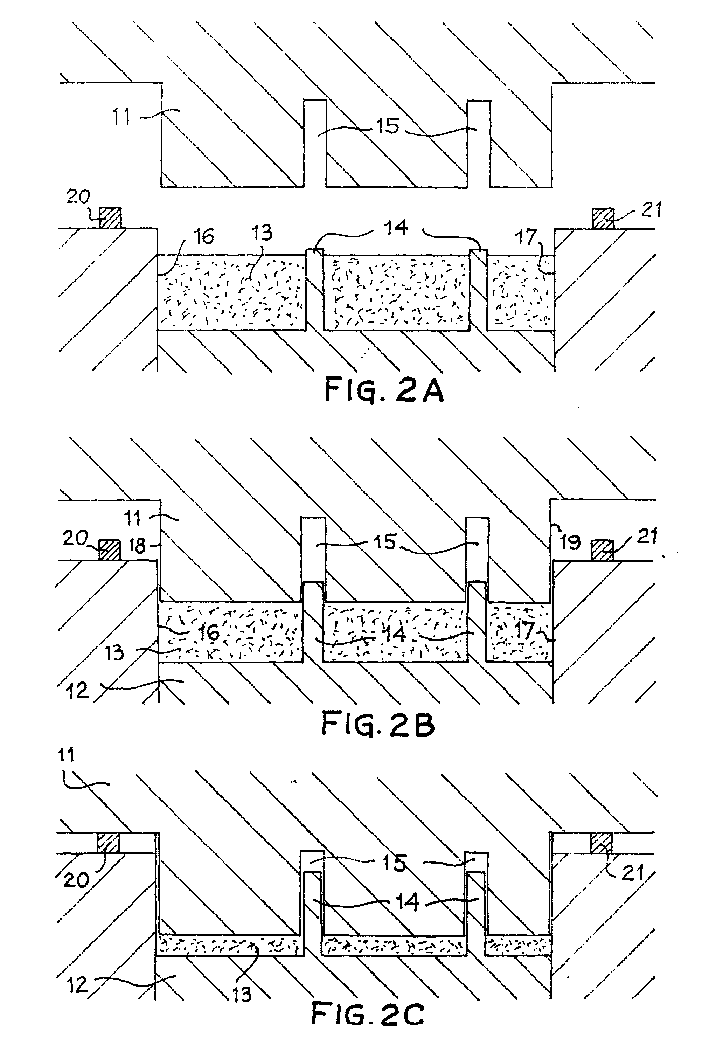

Le substrat 1 comporte deux faces parallèles 2 et 3 percées d'une pluralité de trous 4. Ces trous 4, dans l'art antérieur sont obtenus par perçage d'un substrat brut obtenu par coulée puis découpage. Ces trous 4 peuvent être obtenus dans le cas de l'invention directement au cours du moulage. Pour cela, il suffit d'utiliser par un exemple un moule ayant la forme représentée sur la figure 2.

Sur la figure 2, sont représentés différents détails du moule permettant d'obtenir un substrat selon l'invention et les différentes étapes de pressage. Sur ces figures 2A, 2B et 2C, 11 représente l'empreinte supérieure du moule, 12 l'empreinte inférieure, 14 et 15, respectivement les ergots mâle et femelle du moule, complémentaires l'un de l'autre et 13 la composition céramique selon l'invention. Celle-ci est disposée dans la partie basse 12 du moule comportant des parois latérales 16, 17 qui retiennent la composition céramique. La hauteur de celle-ci, avant pressage, est inférieure à celle des ergots mâles 14 de manière à créer les trous dans le substrat au cours du pressage. La partie supérieure 11 du moule vient coulisser par ses parois latérales 18, 19 le long des parois 16, 17 de la partie inférieure 12 du moule. Sur la figure 2C, les butées schématisées par 20 et 21 stoppent le mouvement relatif des parties supérieure et inférieure, déterminant la fin du pressage. On constate que le granulé de céramique se répartit correctement dans le moule au cours du pressage avec la composition selon l'invention, sans porosité dans le substrat.

Les compositions qui permettant d'obtenir un tel résultat vont être illustrées ci-dessous:

## Exemple 1

On mélange dans un broyeur à bille d'alumine, pendant 10 heures, les composés suivant, en poids:

Première alumine de granulométrie inférieure à 2 μm,
apte à fritter à une température de 1450° C à 1590° C pour une densité en cru de 2,00 à 2,20:   77,4%
Seconde alumine de granulométrie inférieure à 3 μm,
apte à fritter à une température de 1580° C à 1650° C pour une densité en cru de 2,20 à 2,30:   19%
Polyacrylate de butyle (en dispersion aqueuse à 50%):   1,1%
Alcool polyvynilique (en solution 20%):   0,1%
Polyéthylène (en dispersion aqueuse à 20%):   0,4%
Défloculants de type organique:   0,5%

On ajoute de l'eau au mélange de façon à obtenir un rapport matière sèche sur barbotine de l'ordre de 65% à 70%. Le mélange doit être fait en veillant à tout moment à l'équilibre de la préparation.

3

La barbotine ainsi obtenue est atomisée et l'on obtient un granulé après tamisage de granulométrie comprise entre 80 et 250 μm.

Ce granulé est utilisé pour presser mécaniquement dans un moule un substrat de 2,54 cm × 2,54 cm comportant 48 trous calibrés (figure 1), ce substrat pour une densité en cru de 2,45 frittant à une température de 1580°C. La durée du palier de frittage est d'environ 0,5 heure, le profil de température de four passant de 20°C à 1580°C puis à 20°C ce qui donne une durée de frittage d'environ 15 heures. La densité en cuit du substrat est de 3,90. Après auto-polissage dans un tonneau contenant de l'eau pendant 6 heures, on obtient des substrats ayant une rugosité moyenne mesurée à l'aide d'un rugosimètre selon la méthode habituelle, d'environ 0,2 μm (8 μ inch).

### Exemple 2

On procède de la même façon que dans l'exemple 1 en utilisant la composition suivante en extrait sec, en poids:

| | |
|---|---|
| Première alumine: | 70% |
| Deuxième alumine: | 22% |
| Polyacrylate de butyle (en dispersion à 50%): | 0,9% |
| Carboxyméthyl cellulose: | 0,9% |
| Alcool polyvynilique (en solution à 20%): | 0,2% |
| Défloculants de type organique: | 0,5% |
| Talc: | 3% |

En procédant comme précédemment, on obtient des substrats de rugosité sensiblement égale à 0,2 μm ($R_a$), avec des densités en cru et en cuit respectivement de 2,45 et 3,87.

## Revendications

1. Composition céramique comportant notamment en cru de l'alumine, un agent défloculant et au moins un liant organique, caractérisée en ce qu'elle est constituée en extrait sec, de 95 à 99% en poids d'un mélange d'une première alumine ayant une granulométrie comprise entre 0,4 et 0,8 μm, une densité en cru comprise entre 2,00 et 2,20, une densité en cuit comprise entre 3,85 et 3,96 pour une température de frittage de 1450°C à 1580°C, et d'une seconde alumine ayant une granulométrie comprise entre 1,2 et 1,6 μm, une densité en cru inférieure à 2,4, une densité en cuit comprise entre 3,85 et 3,96 pour une température de frittage de 1580°C à 1650°C et de 1 à 5% en poids de produits organiques comportant moins un défloculant et au moins un liant acrylique, à base d'homo ou de copolymères de polyacrylate d'alkyle.

2. Composition céramique selon la revendication 1, caractérisée en ce qu'elle comporte de 97% à 98,5% en poids d'un mélange d'alumine et de 1,5 à 3% en poids de produits organiques.

3. Composition céramique selon l'une des revendications 1 ou 2, caractérisée en ce que le mélange d'alumine comporte de 65 à 95% en poids de la première alumine et de 35 à 5% en poids de la seconde.

4. Composition céramique selon l'une des revendications 1 ou 2, caractérisée en ce que le mélange d'alumine comporte de 70 à 80% en poids de la première alumine et de 30 à 20% en poids de la seconde.

5. Composition céramique selon l'une des revendications 1 à 4, caractérisée en ce qu'elle comporte de plus de 0 à 5% en poids en extrait sec de produits minéraux de granulométrie inférieure à 2 μm, capables de fritter à une température inférieure à 1620°C pour une densité en crue inférieure à 2,45.

6. Composition céramique selon l'une des revendication 1 à 5, caractérisée en ce que le liant est choisi parmi les polyacrylates de butyle et leurs copolymères.

7. Procédé de fabrication d'un substrat du type »chip-carrier«, ledit substrat comportant une pluralité de trous et ayant une rugosité inférieure à 0,254 μm (10 microinches), caractérisé en ce qu'il consiste à:

— réaliser une barbotine comportant de 50 à 75% en poids d'extraits secs constitués d'une composition céramique conforme à l'une des revendications précédentes;
— atomiser cette barbotine, puis la tamiser de manière à obtenir un granulé dont la taille des particules est comprise entre 80 et 250μm;
— presser mécaniquement cette composition dans un moule de manière à obtenir un substrat, ledit substrat ayant des broches correspondant aux trous du substrat;
— fritter ce substrat à une température de l'ordre de 1600°C;
— réaliser un auto-polissage dans un tonneau rempli d'eau d'une pluralité de substrats frittés.

**Patentansprüche**

1. Keramische Zusammensetzung, die insbesondere aus ungesintertem Aluminiumoxid, einem Entflockungsmittel und wenigstens einem organischen Bindemittel besteht, dadurch gekennzeichnet, daß sie gebildet ist aus Trockenmasse mit 95 bis 99 Gewichtsprozent eines Gemisches aus einem ersten Aluminiumoxid mit einer Korngröße zwischen 0,4 und 0,8 μm, einer Rohrdichte zwischen 2,00 und 2,20, einer Dichte im gebrannten Zustand zwischen 3,85 und 3,96 für eine Sintertemperatur von 1450°C bis 1580°C, und einem zweiten Aluminiumoxid mit einer Korngröße zwischen 1,2 und 1,6 μm, einer Rohdichte kleiner als 2,4 einer Dichte im gebrannten Zustand zwischen 3,85 und 3,96 für eine Sintertemperatur von 1580°C bis 1650°C, und mit 1 bis 5 Gewichtsprozent organischer Produkte, die wenigstens ein Entflockungsmittel und wenigstens ein Acrylbindemittel auf der Basis von Homo- oder von Copolymeren von Acrylpolyacrylat umfaßt.

2. Keramische Zusammensetzung nach Anspruch 1, dadurch gekennzeichnet, daß sie 97 bis 98,5 Gewichtsprozent eines Gemisches von Aluminiumoxid und 1,5 bis 3 Gewichtsprozent organischer Produkte umfaßt.

3. Keramische Zusammenfassung nach einem der Ansprüche 1 oder 2, dadurch gekennzeichnet, daß das Gemisch von Aluminiumoxid 65 bis 95 Gewichtsprozent des ersten Aluminiumoxids und 35 bis 5 Gewichtsprozent des zweiten umfaßt.

4. Keramische Zusammensetzung nach Anspruch 1 oder 2, dadurch gekennzeichnet, daß das Gemisch von Aluminiumoxid 70 bis 80 Gewichtsprozent des ersten Aluminiumoxids und 30 bis 20 Gewichtsprozent des zweiten umfaßt.

5. Keramische Zusammensetzung nach einem der Ansprüche 1 bis 4, dadurch gekennzeichnet, daß sie in der Trockenmasse von mehr als 0 bis 5 Gewichtsprozent mineralische Produkte von einer Korngröße kleiner als 2 μm umfaßt, die geeignet sind zum Sintern bei einer Temperatur kleiner als 1620°C für eine Rohrdichte kleiner als 2,45.

6. Keramische Zusammensetzung nach einem der Ansprüche 1 bis 5, dadurch gekennzeichnet, daß das Bindemittel aus den Butylpolyacrylaten und ihren Copolymeren ausgewählt ist.

7. Verfahren zur Herstellung einer Unterlage vom Typ »chip carrier«, die eine Vielzahl von Löchern umfaßt und eine Rauhigkeit kleiner als 0,254 μm (10 Mikroinches) hat, dadurch gekennzeichnet, daß

— eine Aufschlämmung hergestellt wird, die 50 bis 75 Gewichtsprozent Trockenmassen umfaßt, die aus einer keramischen Zusammensetzung gemäß einem der vorhergehenden Ansprüche gebildet sind,

— die Aufschlämmung zerstäubt, dann gesiebt wird um ein Granulat zu erhalten, dessen Teilchengröße 80 bis 250 μm umfaßt,

— diese Zusammensetzung mechanisch in eine Form gepreßt wird, um eine Unterlage zu erhalten, welche Dorne aufweist, die den Löchern der Unterlage entsprechen,

— die Unterlage bei einer Temperatur in der Größenordnung von 1600°C gesintert wird,

— eine Selbstpolitur einer Vielzahl von gesinterten Unterlagen in einer mit Wasser gefüllten Tonne durchgeführt wird.

**Claims**

1. A ceramic composition notably comprising, as unfired, alumina, a deflocculating agent and at least one organic binder, characterized in that it is constituted in dry extract, from 95 to 99% by weight of a mixture of a first alumina having a grain size comprised between 0,4 and 0,8 μm, a density as unfired comprised between 2,00 and 2,20, a density as baked comprised between 3,85 and 3,96 for a sintering temperature of 1450°C to 1580°C, and of a second alumina having a grain size comprised between 1,2 and 1,6 μm, a density as unfired lower than 2,4, a density as baked comprised between 3,85 and 3,96 for a sintering temperature of 1580°C to 1650°C, and from 1 to 5% by weight of organic products comprising at least a deflocculating agent at least an acrylic binder based on homo or copolymers of alkyl polyacrylate.

2. A ceramic composition according to claim 1, characterized in that it comprises from 97% to 98,5% by weight of a mixture of alumina and of 1,5 to 3% by weight of organic products.

3. A ceramic composition according to one of claims 1 or 2, characterized in that the alumina mixture comprises from 65 to 95% by weight of the first alumina and from 35 to 5% by weight of the second alumina.

4. A ceramic composition according to one of claims 1 or 2, characterized in that the alumina mixture comprises from 70 to 80% by weight of the first alumina and from 30 to 20% by weight of the second alumina.

5. A ceramic composition according to one of claims 1 to 4, characterized in that it also comprises from 0 to 5% by weight in dry extract of mineral products of a grain size lower than 2 μm sinterable at a temperature lower than 1620°C for a density as unfired lower than 2,45.

6. A ceramic composition according to one of claims 1 to 5, characterized in that the binder is selected among butyl polyacrylates and their copolymers.

7. A process for preparation of a substrate of the chip carrier type, said substrate comprising a plurality of holes therein and being of a rugosity lower than 0,254 μm, characterized in that it consists of:

— preparing a mortar comprising from 50 to 75% by weight of dry extracts constituted by a ceramic composition in accordance with one of the preceding claims;

— atomizing such mortar, then sifting it so as to obtain a granular product the particle size of which is comprised between 80 and 250 μm;

— mechanically pressing such composition in a mould to obtain a substrate such substrate having pins thereon corresponding to the substrate holes;

— sintering such substrate at a temperature in the order of 1600° C;

— realizing self-polishing of a plurality of sintered substrates in a water filled barrel.

# FIG. 1

FIG. 2A

FIG. 2B

FIG. 2C